Europäisches Patentamt

European Patent Office

Office européen des brevets

(19)

(11) Publication number: 0 377 871

A2

(12) EUROPEAN PATENT APPLICATION

(21) Application number: 89123536.8

(22) Date of filing: 20.12.89

(51) Int. Cl.5: H01L 21/311

(30) Priority: 09.01.89 US 295079

(43) Date of publication of application:
18.07.90 Bulletin 90/29

(84) Designated Contracting States:
DE FR GB IT NL

(71) Applicant: TEXAS INSTRUMENTS
INCORPORATED
13500 North Central Expressway
Dallas Texas 75265(US)

(72) Inventor: Mc Elroy, David J.
Route 1 Box 52W
Rosenberg Texas 77477(US)
Inventor: Gill, Manzur
5310 E. Plantation Oaks
Rosharon Texas 77583(US)
Inventor: Lin, Sung-Wei
8423 Grand Knolls Drive
Houston Texas 77083(US)

(74) Representative: Leiser, Gottfried, Dipl.-Ing. et
al
Patentanwälte Prinz, Leiser, Bunke & Partner
Manzingerweg 7
D-8000 München 60(DE)

(54) Self-aligned window at recessed intersection of insulating regions.

(57) An integrated circuit structure and process relating to a self-aligned window (3) at the recessed junction of two insulating regions (1,2) formed on the surface of a semiconductor body (4). The window may include a trench (5) forming an isolation region between doped semiconductor regions (6,7), or may include an electrical conductor connected to a doped semiconductor region, or may include an electrical conductor (10) separated from doped semiconductor regions by an electrical insulator (9). Embodiments include, but are not limited to, a field-effect transistor, a tunnelling area for a floating gate transistor, and an electrical connection to a doped area of the substrate.

Fig. 1g

## SELF-ALIGNED WINDOW AT RECESSED INTERSECTION OF INSULATING REGIONS

### RELATED CASES

This application discloses subject matter also disclosed in co-pending U.S. Patent Application Serial No. 07/219,529, filed July 15, 1988 and assigned to Texas Instruments Incorporated.

### BACKGROUND OF THE INVENTION

This invention relates to integrated circuit structures and processes and, in particular, to a self-aligned window formed at the recessed junction of two adjacent insulating regions formed on a surface of an integrated-circuit substrate.

Increasing the density of components on integrated circuit causes alignment of photo-masking processes to become more critical. Therefore, it is desirable to design structures and processes such that the number of critical photo-masking alignment steps is minimized.

### SUMMARY OF THE INVENTION

The structure and process described in this invention eliminate one or more critical alignment steps for many integrated circuit processes. A first insulating region is formed on the surface of a semiconductor substrate in a manner such that the insulating region has at least one sloping edge. A second insulating region of field oxide is then formed on the surface adjacent a sloping edge of the first insulating region. The depression between two insulating regions is etched to form a window or a strip through to the substrate, the window or strip alternatively including a trench into the substrate. At least one of the insulating regions may be formed over a doped semiconductor region in the substrate. The other insulating region may be formed over a doped semiconductor region that is either of the same or of opposite type impurity as that of the first doped semiconductor region. Additional doping may be inserted in the window (and trench extension thereof, if applicable) to form a doped semiconductor insertion region. The lower surface and the walls of the window may be insulated. Whether or not the walls are insulated, the window may be filled with electrically conductive or electrically insulating material.

### BRIEF DESCRIPTION OF THE DRAWINGS

The novel features of this invention are set forth in the appended claims. The invention, its features, and its advantages are described below in conjunction with the following drawings:

Figures 1(a)-1(g) are elevation views, in section, of typical embodiments of the structure of this invention at successive stages of manufacture, indicating alternative methods of construction.

Figures 2(a)-2(d) are elevation views, in section, of a typical embodiment of the structure of this invention at successive stages of manufacture, indicating an alternative method of construction.

### DETAILED DESCRIPTION OF SPECIFIC EMBODIMENTS

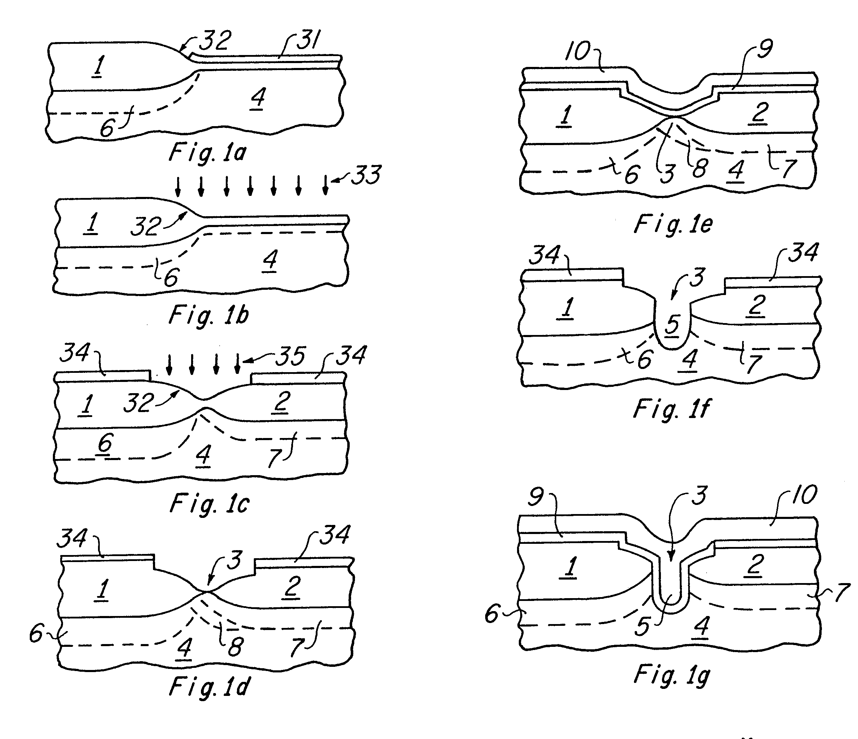

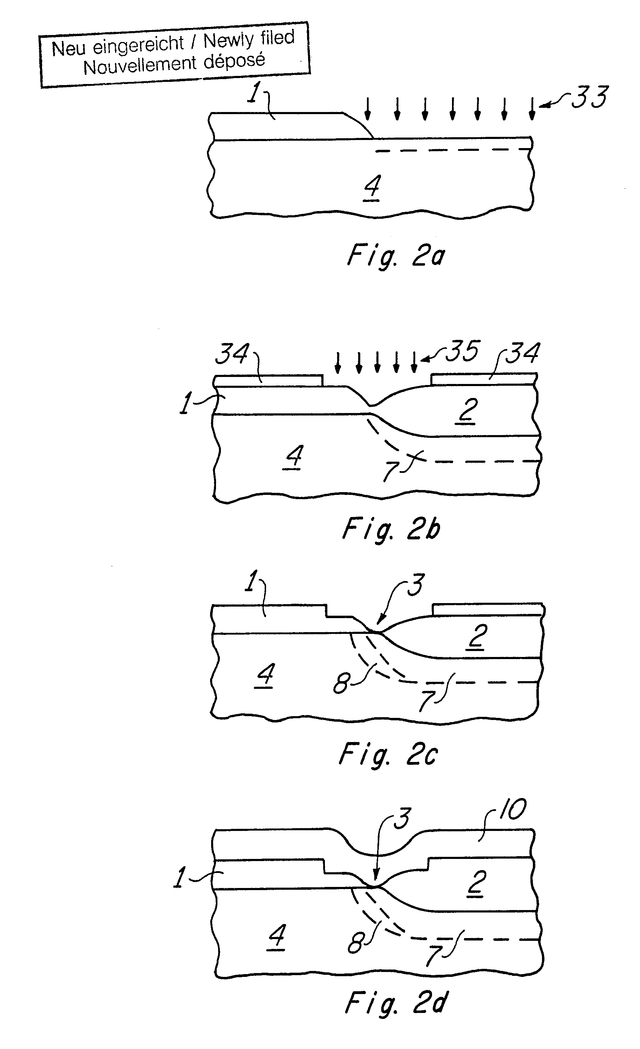

Referring to Figures 1(e), 1(g) and 2(d), the recessed junction of first insulating region 1 and second insulating region 2 has a window or strip 3 that extends from the upper surface of the insulator junction through the insulator junction at least to substrate 4. The window or strip 3 may extend into substrate 4, forming a trench extension 5 of window or strip 3 as shown in Figure 1(g). An optional first doped semiconductor region 6 may be located under first insulating region 1. A second doped semiconductor region 7 may be located under second insulating region 2. An optional doped semiconductor insertion region 8 may be located in the substrate 4 below the window 3. While doped semiconductor insertion region 8 is shown as an extension of second doped semiconductor region 7, it may be an extension of first doped semiconductor region 6. The walls of window 3 and any trench extension 5 thereof may be covered with an electrically insulating material 9, such as oxide or nitride or a combination thereof, in at least the areas adjacent the substrate 4 or adjacent the optional conductive doped semiconductor regions 6, 7 or 8. The window 3, and/or any trench extension 5 thereof, may be filled with an electrically conductive material 10 that contacts at least one of substrate 4 and optional conductive doped semiconductor regions 6, 7 and 8, or is insulated from those regions by electrically insulating material 9.

A method of making the device of Figure 1(e) will be described in reference to Figures 1(a)-1(e). The starting material is a slice of P-type silicon of which the substrate 4 is only a very small portion. The slice is perhaps 6 inches in diameter, while the portion shown in Figure 1(a) is only a few microns wide. A number of process steps may be performed to create electronic components peripheral to the devices formed by the steps discussed here, and these will not be discussed here. The first step related to the structure of this invention may be applying a coating 31 that may include separate layers of oxide and silicon nitride, illustrated in Figure 1(a), and patterning that coating 31 using photoresist to leave nitride over what will include second insulating region 2, while exposing the areas where first insulating region 1 is to be formed. A boron implant at about $8x10^{12}$ cm$^{-2}$ may be performed if it is desired to create a channel-stop-type first doped semiconductor region 6 under first insulating region 1. An arsenic or phosphorus implant may be performed if it is desired to create a first doped region 6 with N-type doping. Then an oxide insulating region 1 may be grown to a thickness of perhaps 2000A to 9000A by exposing to an oxidizing agent such as steam at perhaps 900°C for several hours, less time if arsenic is used for the optional doping step. The thermal oxide grows beneath the edges of the nitride 31, creating a "bird's beak" or sloped edge 32 in first insulating region 1 instead of a sharp transition.

Turning now to Figure 1(b), the nitride 31 is removed and, in the area where the second insulating region 2 is to be formed, an arsenic implant 33, for example, may be performed at a dosage of about $6x10^{15}$ cm$^{-2}$ at 100 KeV, using photoresist as an implant mask for regions where implant is not desired. Second oxide insulating region 2 is grown on the face to a thickness of perhaps 2000 to 3500A. With proper choices of doping material types, doping levels, edge slope, and relative exposure time to steam; a recessed area is formed at the junction of second insulating region 2 with the edge 32 of first insulating region 1. A layer 34 of photoresist may be formed on the structure and masked using non-critical alignment to expose the recessed area. The exposed area may be implanted with an impurity 35 if it is desired to create a doped semiconductor insertion region 8 under window 3. Depending on the application, optional doped semiconductor insertion region 8 may be of the same type doping as either doped semiconductor region 6 or doped semiconductor region 7. In the alternative, the implanting step may be performed after the next step.

In the alternative, doped semiconductor regions 6 or 7 may be formed by well-known double implantation of arsenic and phosphorous, for example. As is also well-known, certain types of doping, such as phosphorous, diffuse under window 3 to eliminate the need for separate implantation of impurity 35 to create optional doped semiconductor insertion region 8.

As shown in Figure 1(c), a window 3 is opened in the junction between first insulating region 1 and second insulating region 2. The window 3 is opened using one of the well-known etching procedures for oxides and extends from the upper surface of the recessed junction through the thickness of the junction at least to the substrate 4.

Referring to Figure 1(d), window 3 may be coated with an oxide or nitride insulator 9 in at least the surface areas of the window comprising doped semiconductor regions 6, 7 or 8. The window 3 may then be filled with electrically conductive material 10 such as polycrystalline silicon or aluminum, as illustrated in Figure 1(e). The conductive material 10 may comprise a floating gate as described in U.S. Patent Application Serial No. 07/219,529. Without optional insulator layer 9, conductive material 10 furnishes an electrical connection to at least one of doped semiconductor regions 6, 7 or 8.

Figure 1(f) discloses an optional process step. In the procedure described, doped semiconductor insertion region 8 is absent and a second etching step is performed following the etching step described in reference to Figure 2(d). The second etching step uses one of the well-known etching methods that absorb silicon substrate 4 rather than oxide, thereby forming a trench extension 5 of window 3. Trench extension 5 may insulate doped semiconductor region 6 from doped semiconductor region 7.

Figure 1(g) illustrates that window 3, including optional trench extension 5, may be coated with an insulator 9 in at least the areas formed by doped semiconductor regions 6 and 7. The window 3 may then be filled with a conductive material 10 such as doped polycrystalline silicon (polysilicon), a silicided polysilicon, or aluminum to form a field-effect transistor if doped semiconductor regions 6 and 7 are of the same type.

An optional method of construction is shown in Figure 2(a), illustrating that insulating region 1 may be formed of a chemically deposited material such as an oxide, or of layers of nitride and oxide. A sloped edge of insulating region 1 may be formed using masking and one of the well-known etching methods that absorb such oxide or nitride. For illustration purposes, optional doped semiconductor region 6 has been omitted from Figure 2(a). Arsenic or similar doping 33 is inserted in the region adjacent to insulating region 1 with insulating region 1 serving as a mask. Implant energy may be similar to that described in reference to Figure 1(a).

Referring to Figure 2(b), insulating region 2 is formed as in the Figure 1(b) by exposure to steam. With proper choice of dopants, doping levels, and edge slope; a recessed area is formed at the junction of insulating region 1 and insulating region 2. As in the explanation above, the recessed area may be masked by layer 34 of photoresist. An implantation 35 may be performed to create doped semiconductor insertion region 8.

As illustrated in Figure 2(c), window 3 is etched through the junction. An optional layer 10 of conducting material formed to contact doped semiconductor region 7 or doped semiconductor insertion region 8 is shown in Figure 2(d). Optional layer 10 may, of course, be separated from the semiconductor region 7 by an insulator in a manner similar to that of Figures 1(e) and 1(g).

While this invention has been described with respect to an illustrative embodiment, this description is not intended to be construed in a limiting sense. Upon reference to this description, various modifications of the illustrative embodiment, as well as other embodiments of the invention, will be apparent to persons skilled in the art. It is contemplated that the appended claims will cover any such modifications or embodiments that fall within the scope of the invention.

## Claims

1. An integrated circuit structure including:
a first insulating region formed with sloped edge on a surface of a substrate, and
a second insulating region formed adjacent said first insulating region on said surface of said substrate,
wherein the recessed junction between said first and second insulating regions has an etched window extending from the recessed upper surface of the junction of said oxide insulating regions through said junction to said surface of said substrate.

2. The structure of Claim 1 wherein said window includes a trench extension into said substrate.

3. The structure of Claim 1 wherein said window contains electrically conductive material.

4. The structure of Claim 1 wherein said substrate has a first doped semiconductor region under said first insulating region.

5. The structure of Claim 1 wherein said substrate has a second doped semiconductor region under said second insulating region.

6. The structure of Claim 1 wherein said substrate has a doped semiconductor region under one of said first and second insulating regions and wherein said doped semiconductor region extends below said window.

7. The structure of Claim 1 wherein a doped semiconductor insertion region is located in said substrate under said window.

8. The structure of Claim 1 wherein a doped semiconductor insertion region is located in said substrate under said window and wherein said window contains electrically conductive material.

9. The structure of Claim 1 wherein a first doped semiconductor region is located under said first insulating region, wherein a second doped semiconductor region is located under said second insulating region, and wherein said second doped semiconductor region is of the same doping type as said first doped semiconductor region.

10. The structure of Claim 1 wherein a first doped semiconductor region is located under said first insulating region, wherein a second doped semiconductor region is located under said second insulating region, and wherein said second doped semiconductor region is of the opposite doping type as said first doped semiconductor region.

11. The structure of Claim 1 wherein a first doped semiconductor region is located under said first insulating region, wherein a second doped semiconductor region is located under said second insulating region, wherein said first doped semiconductor region is of the same doping type as said first doped semiconductor region, and wherein at least the surface of said window adjacent said semiconductor regions is covered with an electrically insulating material and wherein said window is filled with an electrically conducting material.

12. The structure of Claim 1 wherein said first insulating region includes a grown oxide.

13. The structure of Claim 1 wherein said first insulating region includes deposited oxide.

14. The structure of Claim 1 wherein said first insulating region includes deposited oxide and deposited nitride.

15. A process for forming a self-aligned trench in an integrated circuit structure, including:
forming a first insulating region on a substrate surface in a manner such that said first insulating region has a sloped edge,
forming a second insulating region on said substrate surface adjacent said first insulating region such that a depression is formed at the junction of said first and second insulating regions, and
etching a window in said depression formed at said junction of said first and second insulating regions, wherein said window extends from the upper surface of said depression at said junction of said first and second insulating regions through said junction of said first and second insulating regions.

16. The process of Claim 15 wherein said window includes a trench extension into said substrate.

17. The process of Claim 15 wherein said window is at least partially filled with electrically conductive material.

18. The process of Claim 15 wherein doping of a first doped semiconductor region under said first insulating region is performed prior to forming said first insulating region.

19. The process of Claim 15 wherein doping of a first doped semiconductor region under said first insulating region is performed prior to forming said first insulating region, said doping performed in a manner such that said first doped semiconductor region extends under said junction of said first and second insulating regions.

20. The process of Claim 15 wherein doping is inserted through said window into said substrate to form a doped semiconductor insertion region under said window in said substrate.

21. The process of Claim 15 wherein doping of a second doped semiconductor region under said second insulating region is performed prior to forming said second insulating region.

22. The process of Claim 15 wherein doping of a first doped semiconductor region under said first insulating region and doping of a second doped semiconductor region under said second insulating region are performed at least prior to forming said second insulating region and wherein said first and second doped semiconductor regions are doped with the same type of doping material.

23. The process of Claim 15 wherein doping of a first doped semiconductor region under said first insulating region and doping of a second doped semiconductor region under said second insulating region are performed at least prior to forming said second insulating region and wherein said first and second doped semiconductor regions are doped with the opposite type of doping material.

24. The process of Claim 15 wherein said first insulating region and said edge are formed by growing oxide.

25. The process of Claim 15 wherein said first insulating region and said edge are formed by chemical vapor deposition and etching.

Fig. 1a

Fig. 1b

Fig. 1c

Fig. 1d

Fig. 1e

Fig. 1f

Fig. 1g

EP 0 377 871 A2

Neu eingereicht / Newly filed
Nouvellement déposé

*Fig. 2a*

*Fig. 2b*

*Fig. 2c*

*Fig. 2d*